(19) Europäisches Patentamt / European Patent Office / Office européen des brevets

(11) **EP 2 916 118 B1**

(12) **EUROPEAN PATENT SPECIFICATION**

(45) Date of publication and mention of the grant of the patent:
**02.06.2021 Bulletin 2021/22**

(21) Application number: **15157364.9**

(22) Date of filing: **03.03.2015**

(51) Int Cl.:
*G01J 5/02* *(2006.01)*     *G01J 5/06* *(2006.01)*
*H01L 31/0203* *(2014.01)*     *H01L 27/146* *(2006.01)*
*G01J 5/04* *(2006.01)*     *G01J 5/08* *(2006.01)*
*G01J 1/04* *(2006.01)*     *H01L 31/0216* *(2014.01)*

(54) **Infrared sensor module**

Infrarotsensormodul

Module de capteur de rayonnement infrarouge

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **07.03.2014 GB 201404107**

(43) Date of publication of application:
**09.09.2015 Bulletin 2015/37**

(73) Proprietor: **Melexis Technologies NV
3980 Tessenderlo (BE)**

(72) Inventor: **Van Buggenhout, Carl
9300 Aalst (BE)**

(74) Representative: **DenK iP bv
Leuvensesteenweg 203
3190 Boortmeerbeek (BE)**

(56) References cited:
**GB-A- 2 456 058      JP-A- H03 210 437
US-A1- 2005 081 905      US-A1- 2008 291 968**

## Description

### Field of the invention

The invention relates to the field of radiation sensors. More specifically it relates to an infrared sensor assembly with restricted field of view (FOV) and method for its manufacture.

### Background of the invention

Sensors for sensing infrared radiation (IR sensors) have a wide range of applications, for instance gas detectors, motion detectors, thermometers, and the like. For certain applications, sensors need high accuracy and resolution while keeping a reasonably small packaging size. The accuracy of sensors is also related to the degree wherein noise can be avoided. Sources of noise in an infrared sensor are, for instance, detection of radiation from non-envisaged wavelength ranges, disturbance by nearby circuitry of the sensor itself, etc. All these signals disadvantageously add noise to the signal received from the source of interest being measured. Noise from visible light is often dealt with by placing a filter between the source and the sensing element, for instance a semiconductor cap, which blocks visible light but transmits infrared radiation. Packaging size increases only slightly and filtering is improved proportionally to the thickness of the filter.

Another source of noise is the detection of direct or stray radiation from infrared radiation sources that are positioned not in line with the sensing element but that are positioned such that oblique infrared radiation from these sources still can reach the sensor. The detection of this radiation is to be avoided because it obscures the detection of the position of the radiation source and thus lowers the resolution of the sensor. The obvious method to avoid such radiation is by adding an aperture or diaphragm between the source and the sensing element, so the field of view (FOV) is reduced according to the aperture size and the distance between the sensing element and the aperture. Nevertheless, there are several technical, spatial and commercial limitations to the use of diaphragms and apertures due to the limited size of the packaged sensor. The aperture may become itself a source of noise, for instance when its temperature increases. The introduction of cooling systems or tubular apertures reduces this noise but increase the size of the packaged sensor, and for several applications this is seriously detrimental.

In order to increase resolution, meaning to increase the ability to identify with high accuracy the position of the radiation source, a number of approaches have been applied in the past.

US patent application US 2008/0061237 discloses an IR sensor, suitable for detecting gas (via scattered infrared radiation), comprising several noise-shielding features. A first aperture in the housing of the device reduces the field of view. The sensing element ("sensor chip") is covered by a filter ("cap chip") comprising a cavity, effectively blocking the visible light and partially isolating the sensing element from the filter. The filter receptor surface (the area of the "cap chip" facing the housing aperture) is then processed for altering its reflectivity, for instance coated, or patterned, or etched, except for a small central area which becomes a "cap chip" aperture. Hence, FOV is further reduced. The production of the IR sensor nevertheless requires additional manufacturing steps for the processing of the cap surface area and the limitation of the FOV and filtering of the unwanted radiation is highly dependent on the quality of the materials and techniques used in the processing.

US2005081905A1 discloses an infrared detector with a thermopile and a cap. The inner and outer surfaces of the cap have an anti-reflective coating. A metal shield layer may be coated on the outer surface of the encapsulation.

JPH03210437 discloses an infrared sensor element in a cavity wherein infrared rays can enter the cavity via an infrared input unit. In JPH03210437 the thickness of the infrared input unit is preferably as thin as possible such that an improved transmission efficiency of the input unit can be achieved. In JPH03210437 a gold film is present against the side walls of the cavity to reflect the infrared light to the infrared sensor element to prevent that the infrared radiation is absorbed in the wall surface and transformed into heat.

US2008291968 discloses a sensor for detecting electromagnetic radiation comprising a sensor element, a housing, in which the sensor elements is disposed and a radiation inlet window provided in the housing and closed by a material transmissible for the radiation to be detected. The transmissible material is fixed to the housing by fixation means not disposed in the field of view of the sensor element.

GB2456058 discloses an infrared sensor for gas spectrometer sensing applications. It comprises a sensing chip and a cap chip with a Fresnel lens formed by alternating annular rings of highly doped semiconductor and lightly doped semiconductor.

There is still room for improvement or alternatives.

### Summary of the invention

It is an object of embodiments of the present invention to provide a sensor assembly suitable for sensing infrared radiation with good resolution.

The above objective is accomplished by a method and device according to the present invention as defined in independent claims 1 and 7. invention.

In a first aspect, the present invention relates to an infrared sensor assembly for sensing infrared radiation, the sensor assembly comprising: at least one sensing element provided on or embedded in a substrate extending substantially in a substrate plane, a cap for covering the at least one sensing element, the cap comprising an upper wall for receiving radiation incident on the sensor assembly and a plurality of cavity walls arranged to define a cavity between the cap and the substrate for hosting the sensing element, wherein at least one of said cavity walls subtends an angle with respect to the receiving upper wall so as to induce total internal reflection on said at least one of said cavity walls for light incident in a direction substantially perpendicular to the upper wall, and wherein the at least one of said cavity walls comprises a reflective coating.

According to the invention the cap comprises at least one additional wall which is oriented for defining an aperture towards the cavity at least for radiation incident along the normal of the substrate plane, wherein the additional wall is comprised in the cavity and is oriented substantially parallel to the substrate plane. The projection of the additional wall is equal to or smaller than the area of the sensing element and the reflective coating covers part of the additional wall, and forms an aperture therein.

With "reflective coating" is meant that the coating has a reflection coefficient of at least 0.7 for infrared radiation, preferably at least 0.8 or even higher.

It is an advantage of embodiments of the present invention that a sensor assembly with a high signal-to-noise ratio, easy production and limited field of view (FOV) is obtained.

It is an advantage of embodiments of the present invention that the introduction of elements (such as a diaphragm) that increase the packaging size can be avoided.

It is an advantage of embodiments of the present invention that the sensitivity of the device is increased by limiting its field of view, reducing parasitic radiation from surrounding areas of the sensing element. It is an additional advantage of embodiments of the present invention that the sensor assembly does not need extra stacked elements or apertures.

At least one cavity wall, preferably all cavity walls have an orientation (inclination) resulting in total internal reflection (TIR) for light incident in a direction substantially perpendicular to the substrate. TIR advantageously avoids the entrance of noise radiation from the regions surrounding the cavity.

It is an advantage of embodiments of the present invention that the limitation of field of view can be substantially performed via Total Internal Reflection (TIR), and that radiation which would not be reflected by Total Internal Reflection against the inclined cavity wall, is reflected by normal reflection due to the reflective coating, resulting in substantially a total reflection.

The cavity walls (inclined inner walls of the cap) comprise a reflective coating, advantageously promoting reflection for a broader scope of angles of radiation incidence, for which total internal reflection may not be obtained. It is an advantage of embodiments of the present invention that the coating can be chosen to selectively reflect certain wavelengths. The substance used for coating can be chosen to filter out a different range of radiation wavelengths, or vary the angle at which TIR takes place.

It is an advantage of using a reflective coating deposited on the inner inclined walls of the cap that it helps to prevent radiation to enter the cap via unintended paths (via said inclined walls), while at the same time reflecting back inwardly radiation which had entered the cap via intended paths (e.g. through an opening at the top), but which was partly reflected by the sensitive element, so that this portion of the radiation gets a "second chance" of getting absorbed by the sensitive element after reflection against the inner cavity wall.

The at least one sensing element may be for example a thermopile, although any type of infrared sensing element could be used.

In an embodiment, the reflective coating is a metal coating.

Suitable materials are for example Al or Ti, or a coating comprising titanium oxide particles, or nickel manganese. It is an advantage of using a coating process compatible with CMOS processing. It is an advantage of embodiments of the present invention that a limited field of view can be obtained, without the strict need for introducing additional materials into the sensor assembly.

In an embodiment, for an outer material having a refractive index n0, the cap being made of a cap material having a refractive index n1 and the cavity filled with a cavity filling material having a refractive index n2, the angle $\alpha$ being the angle made by the at least one cavity wall with the substrate plane, and fulfilling the relationship

$$\arcsin\left(\frac{n_2}{n_1}\right) - \arcsin\left(\frac{n_0}{n_1}\sin\theta\right) > \alpha$$

, for at least one angle of incidence $\theta$ and advantageously for all possible angles of incidence.

The cavity filling material may have a refraction index n2 different from 1.0.

The cavity may be filled with a fluid or solid material, transparent for infrared.

It is an advantage of embodiments of the present invention that the refraction between the cap and the cavity may be greatly controlled for specific purposes by a selection of said substance.

Alternatively the cavity may comprise a gas at a pressure less than 100 Pa (low vacuum) or at a pressure less than 100 mPa (high vacuum), for which the refraction index is substantially equal to 1.0.

According to the invention, the cap comprises at least one additional wall being oriented for defining an aperture towards the cavity at least for radiation incident along the normal of the substrate plane.

According to the invention, the reflective coating applied to the at least one cavity wall extends partly over the additional wall, and defines an aperture therein.

It is an advantage of such a device that the aperture is not primarily determined by the position of the inclined walls (hence by the etching process), but can be defined by lithography, which is typically more accurate. It is an advantage of such embodiment that the process tolerances can be reduced.

In an embodiment, the cap comprises a semiconductor material, for example silicon or germanium.

The cap may (apart from any coating on its inner or outer walls) be a semiconductor cap, for example germanium, or more preferably silicon, which has a good transparency to infrared radiation. It advantageously may protect the substrate and can act as a filter, e.g. for blocking visible light.

The cap may be made of a capping material adapted for inducing total internal reflection.

In an embodiment, the at least one cavity wall having an orientation resulting in total internal reflection is a wall oriented along a crystal plane of the semiconductor material of the cap.

It is an advantage of embodiments of the present invention that the formation of the cavity in the cap for isolating the sensor and the orientation (inclination) for obtaining TIR can be obtained in the same etching step.

In an embodiment, the at least one cavity wall having an orientation resulting in total internal reflection subtends an angle of about 45° or about 54.7° with the substrate plane.

In an embodiment, the cap comprises, at a wall not defining the interface with the cavity, absorbing and/or reflective elements extending over part of said wall, and defining an aperture for allowing radiation to be sensed by the sensing element.

The cap may comprise, on the outer surface of the upper wall absorbing and/or reflective elements, e.g. an absorbing and/or reflective coating, extending over part of said wall. A part of said wall not comprising such absorbing and/or reflective elements or coating may define an aperture for radiation to be sensed by the sensing element.

According to a second aspect, the present invention also relates to a method for manufacturing an infrared sensor assembly, the method comprising the steps of: providing at least one sensing element on or in a substrate, the substrate substantially extending in a substrate plane; providing a cap comprising at least an upper wall and a plurality of cavity walls, the cavity walls comprising a reflective coating; positioning the cap on the substrate so that the cap covers the at least one sensing element and so that the plurality of cavity walls are arranged to define a cavity between the cap and the substrate hosting the sensing element, wherein the obtaining and positioning is such that at least one of said cavity walls subtends an angle with respect to the receiving upper wall so as to induce total internal reflection on said at least one of said cavity walls for radiation incident thereon.

In an embodiment of the method, for an outer material having a refractive index n0, the cap comprising a cap material having a refractive index n1 and the cavity filled with a cavity filling material having a refractive index n2, said obtaining and positioning is such that the angle $\alpha$, being the angle made by the at least one cavity wall with the substrate

$$\arcsin\left(\frac{n_2}{n_1}\right) - \arcsin\left(\frac{n_0}{n_1}\sin\theta\right) > \alpha$$

plane, is fulfilling the relationship $\qquad$ for at least one angle of incidence $\theta$ and advantageously for all possible angles of incidence $\theta$.

In an embodiment, the method comprises forming the at least one cavity wall using anisotropic wet etching, and applying a reflective coating to the at least one cavity walls, and patterning said reflective coating on the at least one of said cavity walls.

Following the anisotropic etching, the walls forming the cavity would be oriented with respect to the substrate with an angle of about 45° or 54.7° and, in doing so, the FOV is limited by the cavity itself via TIR.

It is an advantage of embodiments of the present invention that the cap for isolating the sensor and the orientation for obtaining TIR can be obtained in the same etching step.

In an embodiment, the method comprises filling the cavity with the cavity material having a refractive index of n2.

In an embodiment, the method comprises fixing the cap to the substrate using a fixing material.

The invention is defined by the appended claims.

These and other aspects of the invention will be apparent from and elucidated with reference to the embodiment(s) described hereinafter.

## Brief description of the drawings

FIG. 1 illustrates a cross-sectional view of a sensor assembly having a substrate and a sensing element covered by a cap having walls oriented for inducing total internal reflection, the inclined walls being coated by a reflective material, according to an embodiment of the present invention.
**FIG. 2** illustrates a cross-sectional view of a sensor assembly according to an embodiment of the present invention, having additionally absorbing and/or reflective elements, e.g. an absorbing or reflective coating present on an outer wall surface of the cap.
**FIG. 3** illustrates a possible sequence of steps for applying the reflective coating to the cavity walls of the cap, as can be used in a method of manufacturing the sensor assembly shown in FIG. 1 or FIG. 2.

The drawings are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.

## Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.
Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.
It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.
Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.
Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.
In the description provided herein, numerous specific details are set forth. However, it is understood that embodiments of the invention may be practiced without these specific details. In other instances, well-known methods, structures and techniques have not been shown in detail in order not to obscure an understanding of this description.
A "sensing element" in the context of embodiments of the present invention is an element which receives a signal, processes it and provides a measurable output. In particular embodiments, the signal refers to electromagnetic radiation in the infrared region, and the sensing element may comprise an integrated circuit, a MEMS, a thermopile or similar measuring systems, which are capable to transform the received signal into an electric signal for example a voltage, which may be then transferred to a readable output (for instance, a display).

Where in embodiments of the present invention reference is made to "cap", reference is made to a cover that protects the sensing element. Some embodiments of the present invention comprise a semiconductor cap, for instance silicon or germanium - the invention not being limited thereto. In embodiments of the present invention, the cap comprises a cavity which isolates the sensing element, which may assist in improving the signal-to-noise ratio. In preferred embodiments of the present invention, the cavity as well as the cap are tailored according to stringent compositional and geometric conditions so that only radiation under specific conditions may be detected by the sensor. The rest of incident radiation suffers from what is known in optics as total internal reflection (TIR), hence not entering the sensor and in consequence effectively reducing the field of view (FOV) and shielding the sensor from noise.

Where in embodiments of the present invention reference is made to "infrared radiation", reference is made to radiation in the wavelength range from 1000 nm to 25000 nm, advantageously in the wavelength range from 5000 nm to 20000 nm

Where in the present invention reference is made to "cavity wall oriented for total internal reflection", or "oriented wall" or "inclined wall", reference is made to the inner walls of the cap showing an inclination angle with respect to the substrate substrate.

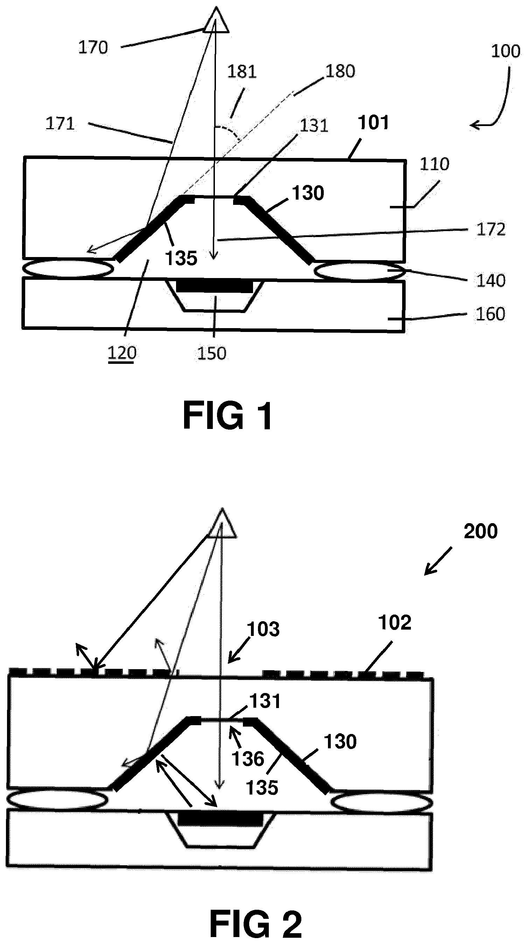

In a first aspect, the present invention relates to an infrared sensor assembly, making reference to a device formed by a sensing element and a stacked cap. Such a device thus is especially suitable for sensing radiation in the infrared region. By way of illustration, embodiments of the present invention not being limited thereto, an exemplary sensor assembly according to embodiments of the present invention is described with reference to **FIG. 1** to FIG. 2, illustrating standard and optional features.

The sensor assembly 100 comprises a cap 110, the cap comprising walls arranged so as to form a cavity 120.

In particular embodiments of the present invention, the cap 110 can be made of a semiconductor material, such as for example germanium or, more preferably, silicon crystal, or more generally any other material that is transparent to the radiation of interest (infrared). Advantageously, such material also is substantially opaque to any other radiation, especially visible light, which is a common source of noise in IR sensors. The cap thus is made of a cap material, characterized by a refractive index n1.

The cap 110 is attached, via fixing means 140, to a substrate 160 containing at least one sensing element 150, such that the cavity 120 harbors and protects the sensing element. The cap and the substrate are fixed with fixing means 140, for instance but not limited to a suitable adhesive, solder balls, solder bumps, bonding material, etc. In an advantageous embodiment of the present invention, the fixing means 140 further isolates the sensing element and keeps the cavity 120 hermetically sealed. The substrate 160 may further comprise an integrated circuit, and the sensing element may be a MEMS, a thermopile, or a similar device for sensing radiation. The cap may be provided so that, to a certain degree, it thermally isolates the sensing element.

In an advantageous embodiment of the present invention, the cap 110 is transparent for the radiation of interest, for instance infrared radiation, and is substantially opaque for the rest of the radiation wavelengths. The latter may assist in improving the signal to noise ratio. When the sensor is exposed to a source of radiation, most of the visible light is absorbed in the cap 110 (e.g. by the cap material itself). Infrared radiation would cross the cap, and would reach a wall 131 interface between the cavity 120 and the cap 110.

The cavity 120 according to embodiments of the present invention comprises at least one wall 130 with a predetermined orientation 180 forming an angle with the normal of the substrate 160. As indicated above, the cap is characterized by a refractive index n1 with respect to the wavelength of the radiation of interest. The refractive index may vary for different wavelengths and when reference is made to criteria required for the refractive index, reference is made to criteria for the wavelength range of interest. The cavity typically is filled with a cavity fill material having a refractive index n2.

According to embodiments of the present invention, the predetermined orientation 180 of the at least one wall (e.g. inclined wall) is chosen so that it subtends an angle $\alpha$ being the angle made by the at least one cavity wall with the

$$\arcsin\left(\frac{n_2}{n_1}\right) - \arcsin\left(\frac{n_0}{n_1}\sin\theta\right) > \alpha$$

substrate plane, and fulfilling the relationship for at least one angle of incidence $\theta$ and advantageously for all possible angles of incidence. The outer material thereby has a refractive index n0.

With this setup, the radiation reaching the sensing element (radiation of interest 172) is radiation from the source of interest 170 that has entered the cavity through certain walls of the cavity, not through the oriented wall(s) 130. This results in the fact that the detection of radiation sources can be performed with a relative high resolution. The sensing element 150 is effectively shielded from noise from radiation sources not positioned accurately in line with the sensing elements.

In case of for example a silicon cap and an air filled cavity or vacuum cavity, the refractive index (n1) for the cap in the infrared region will be close to 3.4, and the refractive index (n2) for the cavity will be about 1.0. Orientations can be chosen for the oriented silicon wall so that total internal reflectance (TIR) is obtained. If radiation is incident on the oriented wall(s) 130, it thus will not enter the cavity 120 but will be reflected by total internal reflection, whereas if the radiation is incident on certain other walls 131 of the cavity, the radiation will enter the cavity and can be detected by the sensor element 150. In embodiments of the present invention, the angle 181 of the oriented wall(s) 130 may in one example have a value between 35.3° and 45°.

According to the invention, an additional wall 131 is comprised in the cavity. Said additional wall 131 is oriented substantially parallel to the substrate plane, and the projection of the area of the additional wall 131 coincides with the sensing element 150. By choosing a suitable area of the additional wall 131,

in accordance with the invention such that its projection is equal to or smaller than the area of the sensing element 150, the FOV is further effectively reduced. This way, mainly the radiation of interest 172 from the source 170 will reach the sensing element by falling into the additional wall 131. Other sources of radiation will be reflected via TIR.

The inclined inner walls 130 of the cap 120 are further provided with a reflective coating 135, for instance a coating of titanium oxide, or nickel manganese, or Al or Ti. Such a coating further assist in optimizing the selectivity of the radiation that is received in the cap. It is an advantage of embodiments of the present invention that radiation whose angle of incidence would not fulfill the TIR condition, is substantially further blocked via normal reflection. Noise is thus avoided. An effective limitation of field of view is then obtained, via TIR and/or normal reflection. An additional advantage of embodiments of the present invention is that the coating can be chosen to block a range of wavelengths, for instance but not limited to visible light.

**FIG. 2** shows a variant of the embodiment of the sensor assembly shown in FIG. 1, whereby additional patterning, reflecting elements or coatings and absorbing elements or coatings, or a combination of them, may be added to the surface 101 not forming the interface with the cavity, in particular the upper outside surface of the cap, parallel to the substrate surface. The area of the surface comprising such patterned/absorbing/reflecting features may be a defined area of the cap surface 101 which is exposed to the source radiation. Said surface is typically parallel to the surface 131 on the inside of the cavity. The reflecting or absorbing elements may act as blocking elements. These blocking elements (like a pattern or texture, reflective or absorbing elements or a combination of both, or for instance a reflective coating or an absorbing coating) may define an additional aperture 103 which further limits the field of view and improves the efficiency of the TIR of the oriented walls 130. The effect of these elements is the reduction of amount of radiation reaching the one or more oriented wall(s) 130.

In case the reflective coating 135 also covers part of the additional surface 131, and forms an aperture 136 therein, incident radiation can only reach the sensing element 150 after passing through both the outer aperture 103 and the inner aperture 136, which are aligned to each other and to the sensing element. In this way the FOV can be precisely determined.

Once the sensing element 150 receives the radiation, in particular embodiments of the present invention its energy is converted to an electrical signal, for instance through difference of potential in a thermopile, and the electrical signal is driven, for instance through an integrated circuit, to a display.

In embodiments of the present invention, the oriented wall can be selected such that all incident radiation that falls into the oriented wall 130 will be reflected via TIR instead of being transmitted into the cavity. In advantageous embodiments of the present invention, the TIR is tuned for a range of angles of incidence. TIR is a process that relies heavily on particular wavelength ranges of the incident radiation. Angular conditions for the TIR of radiation with certain wavelengths may not be valid for other range of wavelengths, because the value of the refraction index changes with the wavelength. For instance; this may happen in the case of an oriented wall optimized to reflect near-IR via TIR, the wall receiving a certain amount of far-IR. Undesired radiation 171 from the radiation source of interest 170 may enter into the cavity: the FOV would be only limited for a range of wavelengths. To limit the FOV for a wider radiation spectrum, certain embodiments of the present invention may also include reflecting elements, e.g. a reflective coating applied to the oriented wall 130, producing TIR in a significant part of incident radiation, and reflecting radiation of different wavelength. This reflective coating may comprise a coating of aluminum particles, for instance. This increases the range of wavelengths for which the field of view is limited.

In a second aspect, the present invention relates to a method for manufacturing a sensor assembly. The method may in particular be used for manufacturing sensor assembly devices as described in the first aspect, although embodiments of the present invention are not limited thereto.

Firstly, a sensing element 150 is provided, whereby the sensing element typically is positioned on or embedded in a substrate 160. This sensing element 150 may be a solid state sensor included in an integrated circuit in the substrate, or it may be a thermopile, or any other suitable device. In some embodiments, a plurality of sensing elements may be provided, arranged to each receive a portion of infrared radiation, in order to identify the position of the source 170 where the infrared radiation 171, 172 is generated. According to embodiments of the present invention, the substrate 160 wherein the sensing element 150 is positioned is substantially extending in a substrate plane.

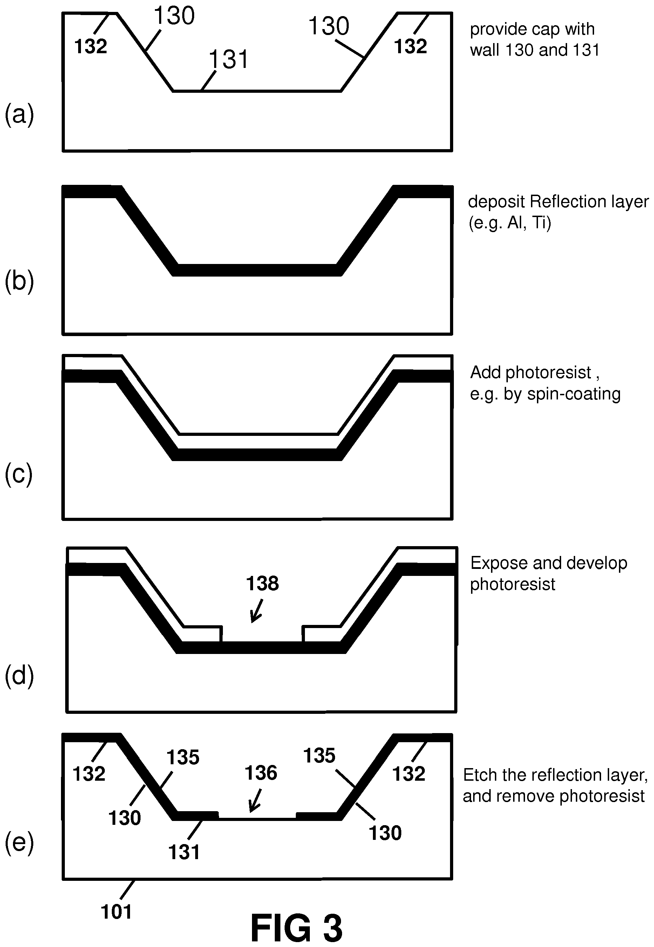

Secondly, a cap 110 is provided. The cap may advantageously be a Si cap or a Ge cap. The cap typically may be etched in a particular way, such that a cavity 120 is induced in the cap, thereby forming a plurality of walls 101, 130, 131, 132, as shown in FIG 3(a). A reflective coating 135 is then applied to some of the walls, in particular to the inclined walls 130, and optionally also the part of the additional wall 131, as will be described further in more detail when discussing FIG. 3.

The first step (providing the substrate with sensor element) and second step (providing the cap) can be interchanged in order.

In a third step, the cap 110 is positioned on the substrate 160 and mounted thereto, in such a way that the cap 110 covers the at least one sensing element 150 and such that the plurality of the walls 130, 131, are arranged so that the cavity between the cap and the substrate is hosting the sensing element 150. The cavity typically may be filled with cavity filling material. This may be applied in a separate step, may be performed in the second step, or may be e.g. automatically fulfilled if the material used is air.

The positioning is such that the cavity comprises at least one wall 130 with an orientation with respect of the substrate plane such that incident radiation 171 falling into the wall 130 typically suffers from total internal reflection (TIR) and thus does not reach the sensing element 150 because it does not enter the cavity 120. This can be obtained for instance by orienting the wall 130 with an orientation defined as follows.

For an outer material having a refractive index n0, the cap being made of a cap material having a refractive index n1 and the cavity filled with a cavity filling material having a refractive index n2, the angle $\alpha$ being the angle made by the oriented cavity wall with the substrate plane may be fulfilling the relationship

$$\arcsin\left(\frac{n_2}{n_1}\right) - \arcsin\left(\frac{n_0}{n_1}\sin\theta\right) > \alpha$$

for at least one angle of incidence $\theta$ and advantageously for all possible angles of incidence.

The cavity 120 may be produced in the cap 110 by etching, for instance by wet etching. In an advantageous embodiment of the present method, the cap is monocrystalline and the cavity may be etched using anistropic etching, for instance using Tetramethylammonium hydroxide (TMAH) or potassium hydroxide (KOH), creating oriented wall 130 (inclined with respect to substrate) and additional wall 131 (parallel to substrate) following certain plane orientations. For instance, if the cap follows the (100) orientation and the etching follows the (111) planes, the oriented walls would subtend an angle of 54.7° with respect the substrate plane (or 35.3° with the normal of the substrate plane). For other suitable conditions and etching temperature the subtended angle of the oriented walls may be different, for instance 45°. The cavity walls, both oriented wall 130 and additional wall 131, may advantageously be formed in one unique etching step. The final area of the additional wall 131 is chosen according to the area of the sensing element, to ensure FOV limitation: for instance, the area of the additional wall 131 shall be the same or smaller as the area of the sensing element. The area of this additional wall 131 is controlled by factors like the etching time, etching area, and the depth of the cavity.

**FIG. 3(a) to FIG. 3(e)** shows a possible way to apply a reflective coating to the cap 110. **FIG. 3(a)** shows an example of a cap obtainable by the steps described above (after anisotropic etching).

**FIG. 3(b)** shows the cap after a reflection layer, e.g. a metal coating, is applied to one surface of the cap, in particular to the oriented wall 130 and to the additional wall 131. The metal coating layer may have a thickness in the range of 100 nm to 800 nm, for example about 400 nm.

**FIG. 3(c)** shows the cap after a photoresist layer is added on top of the reflective coating, e.g. by spin-coating or spray coating.

**FIG. 3(d)** shows the cap after exposure and development of the photoresist. In the example shown, the opening 138 made has a smaller size than the area of the additional wall 131, but the opening 138 could also be made substantially the same size (thus extending to the edges of the oriented walls 130).

**FIG. 3(e)** shows the cap after etching of the reflection layer, and removal of the photoresist. In the example shown, the reflective coating is also applied to the wall portions 132 that will be mounted to the substrate, but that is not mandatory. Depending on the mounting technique used, part of the reflective coating could also be removed from the wall portions 132, to improve the fixation of the cap to the substrate.

Further steps (not shown) can be performed on the cap, for instance by, but not limited to, etching, patterning or grinding of reflecting and absorbing elements on the cap surface 101 opposite to the surface comprising the cavity (i.e. part of the cap forming an outer surface of the assembly). A region in the cap surface 101 (for instance, a region coinciding with the projection of the additional cavity wall 131, or with the aperture 136 thereof) may be left transparent (e.g. uncovered by reflective or absorbing material), so that an additional aperture 103 (see FIG. 2) is defined in the outer surface of the sensor, further shielding the sensing element from noise radiation and further reducing the FOV.

While not limiting the scope of the present invention, additional optical elements or further processing, or a combination of both, may be included to improve FOV limitation. For instance, a cap may comprise absorbing or reflective elements, or both, in or on a wall opposite to the walls defining the cavity, further limiting the FOV of radiation even upon entering the cap material. Other additions are envisaged, for instance adding a diaphragm or a cold shield for protecting the sensor. A part of the wall may comprise such additional features and another part of the wall may not comprise such features.

REFERENCES

| | | | |
|---|---|---|---|
| 100, 200 | infrared sensor assembly | | |
| 101 | upper (outer) wall | | |
| 102 pattern/absorbing/reflecting elements/coating | | | |
| 103 | aperture on the outer wall | | |
| 110 | cap | 120 | cavity |
| 130 | oriented wall (= inclined wall) | 131 | additional wall |
| 132 wall section for mounting the cap to the substrate | | | |
| 135 | reflective coating | 136 | aperture on additional wall |
| 138 | opening in the photoresist | 150 | sensing element |
| 160 | substrate | 170 | IR source |
| 171 | IR radiation | 180 | orientation of inclined wall |
| 181 angle between normal to the substrate and orientation of inclined wall(s) | | | |

**Claims**

1.  An infrared sensor assembly (100; 200) for sensing infrared radiation (172), the sensor assembly comprising :

    - at least one sensing element (150) provided on or embedded in a substrate (160) extending substantially in a substrate plane,
    - a cap (110) for covering the at least one sensing element (150), the cap (110) comprising an upper wall (101) for receiving radiation incident on the sensor assembly and a plurality of cavity walls(130, 131) arranged to define a cavity (120) between the cap (110) and the substrate (160) for hosting the sensing element (150), wherein at least one of said cavity walls (130) subtends an angle (181) with respect to the receiving upper wall (101) so as to induce total internal reflection on said at least one of said cavity walls for light incident in a direction substantially perpendicular to the upper wall,
    the cap (110) comprises at least one additional wall (131) being oriented for defining an aperture towards the cavity (120) at least for radiation incident along the normal of the substrate plane, wherein the additional wall (131) is comprised in the cavity and is oriented substantially parallel to the substrate plane,
    and wherein the at least one of said cavity walls (130) comprises a reflective coating (135) wherein the coating (135) is reflective for infrared radiation, **characterized in that** the reflective coating has a reflection coefficient of at least 0.7 for infrared radiation, and that the projection of the additional wall (131) is equal to or smaller than the area of the sensing element (150) and that the reflective coating (135) applied to said at least one cavity wall extends partly to the additional wall (131), and forms an aperture (136) therein.

2.  An assembly of claim 1, wherein the reflective coating is a metal coating.

3.  An assembly according to any of the previous claims, wherein the cap (110) comprises a semiconductor material, for example silicon or germanium.

4.  An assembly according to claim 3, wherein the at least one cavity wall (130) having an orientation (180) resulting in total internal reflection is a wall oriented along a crystal plane of the semiconductor material of the cap.

5.  An assembly according to claim 3 or 4, wherein the at least one cavity wall (130) having an orientation (180) resulting in total internal reflection subtends an angle (181) of 45° or 54.7° with the substrate plane.

6.  An assembly (200) according to any of the previous claims, wherein the cap (110) comprises, at a wall (101) not defining the interface with the cavity (120), absorbing and/or reflective elements (102) extending over part of said wall (101), and defining an aperture (103) for allowing radiation to be sensed by the sensing element (105).

7. A method for manufacturing an infrared sensor assembly (100; 200), the method comprising

- providing at least one sensing element (150) on or in a substrate (160), the substrate substantially extending in a substrate plane,
- providing a cap (110) comprising at least an upper wall (101) and a plurality of cavity walls (130), the cap (110) comprising at least one additional wall (131) being oriented for defining an aperture towards the cavity (120) at least for radiation incident along the normal of the substrate plane, wherein the additional wall (131) is comprised in the cavity and is oriented substantially parallel to the substrate plane, the cavity walls (130) comprising a reflective coating (135) wherein the coating (135) is reflective for infrared radiation;
- positioning the cap on the substrate so that the cap (110) covers the at least one sensing element (150) and so that the plurality of cavity walls (130, 131) are arranged to define a cavity (120) between the cap and the substrate hosting the sensing element (150),
wherein the obtaining and positioning is such that at least one of said cavity walls (130) subtends an angle (181) with respect to the receiving upper wall (101) so as to induce total internal reflection on said at least one of said cavity walls (130) for radiation incident thereon in a direction substantially perpendicular to the upper wall **characterized in that** the method comprises providing a cap wherein the reflective coating (135) has a reflection coefficient of at least 0.7 for infrared radiation, and wherein the projection of the additional wall (131) is equal to or smaller than the area of the sensing element (150) and wherein the reflective coating applied to the at least one cavity wall (130) extends partly to the additional wall (131), and forms an aperture (136) therein.

8. A method according to claim 7, wherein the method comprises forming the at least one cavity wall (130) using anisotropic wet etching, and applying a reflective coating to the at least one cavity walls (130), and patterning said reflective coating on the at least one of said cavity walls (130).

9. A method according to claim 7 or 8, wherein the method comprises filling the cavity with the cavity material having a refractive index of n2 different from 1.0.

10. A method according to any of claims 7 to 9, wherein the method comprises fixing the cap (110) to the substrate (160) using a fixing material.

**Patentansprüche**

1. Eine Infrarotsensoranordnung (100; 200) zum Erfassen von Infrarotstrahlung (172), wobei die Sensoranordnung umfasst:

- zumindest ein Erfassungselement (150), das auf einem Substrat (160) bereitgestellt oder darin eingebettet ist und sich im Wesentlichen in einer Substratebene erstreckt,
- eine Kappe (110) zum Abdecken des zumindest einen Erfassungselements (150), wobei die Kappe (110) eine obere Wand (101) zum Empfangen von auf die Sensoranordnung einfallender Strahlung und eine Vielzahl von Hohlraumwänden (130, 131) umfasst, die so eingerichtet sind, dass sie einen Hohlraum (120) zwischen der Kappe (110) und dem Substrat (160) zur Aufnahme des Erfassungselements (150) definieren,
- wobei zumindest eine der Hohlraumwände (130) einen Winkel (181) in Bezug auf die empfangende obere Wand (101) einschließt, um eine innere Totalreflexion an der mindestens einen der Hohlraumwände für Licht zu induzieren, das in einer Richtung im Wesentlichen senkrecht zu der oberen Wand einfällt,
- die Kappe (110) zumindest eine zusätzliche Wand (131) umfasst, die so ausgerichtet ist, dass sie eine Öffnung zu dem Hohlraum (120) hin zumindest für Strahlung definiert, die entlang der Normalen der Substratebene einfällt, wobei die zusätzliche Wand (131) in dem Hohlraum enthalten ist und im Wesentlichen parallel zu der Substratebene ausgerichtet ist,
- und wobei die zumindest eine der Hohlraumwände (130) eine reflektierende Beschichtung (135) umfasst, wobei die Beschichtung (135) für Infrarotstrahlung reflektierend ist, **dadurch gekennzeichnet, dass** die reflektierende Beschichtung einen Reflexionskoeffizienten von mindestens 0,7 für Infrarotstrahlung aufweist, und dass die Projektion der zusätzlichen Wand (131) gleich oder kleiner als die Fläche des Erfassungselements (150) ist, und dass sich die reflektierende Beschichtung (135), die auf die zumindest eine Hohlraumwand aufgebracht ist, teilweise auf die zusätzliche Wand (131) erstreckt und darin eine Öffnung (136) bildet.

**2.** Eine Anordnung nach Anspruch 1, wobei die reflektierende Beschichtung eine Metallbeschichtung ist.

**3.** Eine Anordnung nach einem der vorstehenden Ansprüche, wobei die Kappe (110) ein Halbleitermaterial, zum Beispiel Silizium oder Germanium, umfasst.

**4.** Eine Anordnung nach Anspruch 3, wobei die zumindest eine Hohlraumwand (130) mit einer Ausrichtung (180), die zu einer inneren Totalreflexion führt, eine Wand ist, die entlang einer Kristallebene des Halbleitermaterials der Kappe ausgerichtet ist.

**5.** Eine Anordnung nach Anspruch 3 oder 4, wobei die zumindest eine Hohlraumwand (130) mit einer Ausrichtung (180), die zu einer inneren Totalreflexion führt, einen Winkel (181) von 45° oder 54,7° mit der Substratebene einschließt.

**6.** Eine Anordnung (200) nach einem der vorstehenden Ansprüche, wobei die Kappe (110) an einer Wand (101), die nicht die Grenzfläche mit dem Hohlraum (120) definiert, absorbierende und/oder reflektierende Elemente (102) umfasst, die sich über einen Teil der Wand (101) erstrecken und eine Öffnung (103) definieren, um zu ermöglichen, dass Strahlung von dem Fühlelement (105) erfasst wird.

**7.** Ein Verfahren zur Herstellung einer Infrarotsensoranordnung (100; 200), wobei das Verfahren umfasst

- Bereitstellen von zumindest einem Erfassungselement (150) auf oder in einem Substrat (160), wobei sich das Substrat im Wesentlichen in einer Substratebene erstreckt,
- Bereitstellen einer Kappe (110), die mindestens eine obere Wand (101) und eine Vielzahl von Hohlraumwänden (130) umfasst, wobei die Kappe (110) zumindest eine zusätzliche Wand (131) umfasst, die so ausgerichtet ist, dass sie eine Öffnung in Richtung des Hohlraums (120) zumindest für Strahlung definiert, die entlang der Normalen der Substratebene einfällt, wobei die zusätzliche Wand (131) in dem Hohlraum enthalten ist und im Wesentlichen parallel zu der Substratebene ausgerichtet ist, wobei die Hohlraumwände (130) eine reflektierende Beschichtung (135) umfassen, wobei die Beschichtung (135) für Infrarotstrahlung reflektierend ist;
- Positionieren der Kappe auf dem Substrat, so dass die Kappe (110) das zumindest eine Erfassungselement (150) bedeckt und dass die Vielzahl von Hohlraumwänden (130, 131) so angeordnet sind, dass sie einen Hohlraum (120) zwischen der Kappe und dem Substrat, welches das Erfassungselement (150) aufnimmt, definieren,
- wobei das Erhalten und Positionieren derart ist, dass zumindest eine der Hohlraumwände (130) einen Winkel (181) in Bezug auf die empfangende obere Wand (101) einschließt, um eine innere Totalreflexion an der zumindest einen der Hohlraumwände (130) für Strahlung zu induzieren, die darauf in einer Richtung im Wesentlichen senkrecht zu der oberen Wand einfällt,
- **dadurch gekennzeichnet, dass** das Verfahren das Bereitstellen einer Kappe umfasst, wobei die reflektierende Beschichtung (135) einen Reflexionskoeffizienten von mindestens 0,7 für Infrarotstrahlung aufweist, und wobei die Projektion der zusätzlichen Wand (131) gleich oder kleiner als die Fläche des Erfassungselements (150) ist und wobei sich die reflektierende Beschichtung, die auf die mindestens eine Hohlraumwand (130) aufgebracht wurde, teilweise auf die zusätzliche Wand (131) erstreckt und darin eine Öffnung (136) bildet.

**8.** Ein Verfahren nach Anspruch 7, wobei das Verfahren das Ausbilden der zumindest einen Hohlraumwand (130) unter Verwendung eines anisotropen Nassätzens und das Aufbringen einer reflektierenden Beschichtung auf die zumindest eine Hohlraumwand (130) und das Strukturieren der reflektierenden Beschichtung auf der zumindest einen der Hohlraumwände (130) umfasst.

**9.** Ein Verfahren nach Anspruch 7 oder 8, wobei das Verfahren das Füllen des Hohlraums mit dem Hohlraummaterial umfasst, das einen von 1,0 verschiedenen Brechungsindex von n2 aufweist.

**10.** Ein Verfahren nach einem der Ansprüche 7 bis 9, wobei das Verfahren das Befestigen der Kappe (110) an dem Substrat (160) unter Verwendung eines Befestigungsmaterials umfasst.

**Revendications**

**1.** Un ensemble capteur infrarouge (100 ; 200) pour détecter un rayonnement infrarouge (172), l'ensemble capteur comprenant :

- au moins un élément de détection (150) fourni sur ou incrusté dans un substrat (160) s'étendant sensiblement dans un plan de substrat,
- un capuchon (110) pour recouvrir le au moins un élément de détection (150), le capuchon (110) comprenant une paroi supérieure (101) pour recevoir un rayonnement incident sur l'ensemble capteur et une pluralité de parois de cavité (130, 131) agencées pour définir une cavité (120) entre le capuchon (110) et le substrat (160) pour accueillir l'élément de détection (150),
dans lequel au moins l'une desdites parois de cavité (130) sous-tend un angle (181) par rapport à la paroi supérieure de réception (101) de manière à induire une réflexion interne totale sur ladite au moins une desdites parois de cavité pour une lumière incidente dans une direction sensiblement perpendiculaire à la paroi supérieure,
le capuchon (110) comprend au moins une paroi (131) supplémentaire étant orientée pour définir une ouverture vers la cavité (120) au moins pour un rayonnement incident le long de la normale du plan de substrat, dans lequel la paroi (131) supplémentaire est comprise dans la cavité et est orientée sensiblement parallèle au plan de substrat,
et dans lequel la au moins une desdites parois de cavité (130) comprend un revêtement réfléchissant (135) dans lequel le revêtement (135) réfléchit un rayonnement infrarouge,
**caractérisé en ce que** le revêtement réfléchissant présente un coefficient de réflexion d'au moins 0,7 pour un rayonnement infrarouge, et que la saillie de la paroi (131) supplémentaire est inférieure ou égale à la superficie de l'élément de détection (150) et **en ce que** le revêtement réfléchissant (135) appliqué sur ladite au moins une paroi de cavité s'étend partiellement vers la paroi (131) supplémentaire, et forme une ouverture (136) à l'intérieur.

2. Un ensemble selon la revendication 1, dans lequel le revêtement réfléchissant est un revêtement métallique.

3. Un ensemble selon l'une quelconque des revendications précédentes, dans lequel le capuchon (110) comprend un matériau semi-conducteur, par exemple du silicium ou du germanium.

4. Un ensemble selon la revendication 3, dans lequel la au moins une paroi de cavité (130) présentant une orientation (180) donnant une réflexion interne totale est une paroi orientée le long d'un plan cristallin du matériau semi-conducteur du capuchon.

5. Un ensemble selon la revendication 3 ou 4, dans lequel la au moins une paroi de cavité (130) présentant une orientation (180) donnant une réflexion interne totale sous-tend un angle (181) de 45° ou 54,7° avec le plan de substrat.

6. Un ensemble (200) selon l'une quelconque des revendications précédentes, dans lequel le capuchon (110) comprend, au niveau d'une paroi (101) ne définissant pas l'interface avec la cavité (120), des éléments absorbants et/ou réfléchissants (102) s'étendant sur une partie de ladite paroi (101), et définissant une ouverture (103) pour permettre à un rayonnement d'être détecté par l'élément de détection (105).

7. Un procédé de fabrication d'un ensemble capteur infrarouge (100 ; 200), le procédé comprenant

- la fourniture d'au moins un élément de détection (150) sur ou dans un substrat (160), le substrat s'étendant sensiblement dans un plan de substrat,
- la fourniture d'un capuchon (110) comprenant au moins une paroi supérieure (101) et une pluralité de parois de cavité (130), le capuchon (110) comprenant au moins une paroi (131) supplémentaire orientée pour définir une ouverture vers la cavité (120) au moins pour un rayonnement incident le long de la normale du plan de substrat, dans lequel la paroi (131) supplémentaire est comprise dans la cavité et est orientée sensiblement parallèle au plan de substrat, les parois de cavité (130) comprenant un revêtement réfléchissant (135) dans lequel le revêtement (135) réfléchit un rayonnement infrarouge ;
- le positionnement du capuchon sur le substrat de sorte que le capuchon (110) recouvre le au moins un élément de détection (150) et de sorte que la pluralité de parois de cavité (130, 131) soient agencées pour définir une cavité (120) entre le capuchon et le substrat accueillant l'élément de détection (150), dans lequel l'obtention et le positionnement sont tels qu'au moins l'une desdites parois de cavité (130) sous-tend un angle (181) par rapport à la paroi supérieure de réception (101) de manière à induire une réflexion interne totale sur ladite au moins une desdites parois de cavité (130) pour un rayonnement incident sur celle-ci dans une direction sensiblement perpendiculaire à la paroi supérieure,
**caractérisé en ce que** le procédé comprend la fourniture d'un capuchon dans lequel le revêtement réfléchissant (135) présente un coefficient de réflexion d'au moins 0,7 pour un rayonnement infrarouge, et dans lequel la saillie de la paroi (131) supplémentaire est inférieure ou égale à la superficie de l'élément de détection (150) et dans lequel le revêtement réfléchissant appliqué sur la au moins une paroi de cavité (130) s'étend partiellement vers la paroi (131) supplémentaire, et forme une ouverture (136) à l'intérieur.

8. Un procédé selon la revendication 7, dans lequel le procédé comprend la formation de la au moins une paroi de cavité (130) en utilisant une gravure humide anisotrope, et l'application d'un revêtement réfléchissant sur la au moins une paroi de cavité (130), et la mise en forme dudit revêtement réfléchissant sur la au moins une desdites parois de cavité (130).

9. Un procédé selon la revendication 7 ou 8, dans lequel le procédé comprend le remplissage de la cavité avec le matériau de cavité présentant un indice de réfraction n2 différent de 1,0.

10. Un procédé selon l'une quelconque des revendications 7 à 9, dans lequel le procédé comprend la fixation du capuchon (110) sur le substrat (160) en utilisant un matériau de fixation.

**FIG 1**

**FIG 2**

(a)

132  130  130  130  132
131

provide cap with
wall 130 and 131

(b)

deposit Reflection layer
(e.g. Al, Ti)

(c)

Add photoresist ,
e.g. by spin-coating

(d)

138

Expose and develop
photoresist

(e)

132  135  136  135  132
130  130
131
101

Etch the reflection layer,
and remove photoresist

# FIG 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080061237 A
- US 2005081905 A1
- US 2008291968 A
- GB 2456058 A